# EUROPÄISCHE PATENTSCHRIFT

(11) **EP 1 602 263 B1**
(45) Veröffentlichungstag und Bekanntmachung des Hinweises auf die Patenterteilung: **09.12.2015**
(21) Anmeldenummer: 04715300.2
(22) Anmeldetag: 27.02.2004
(51) Int. Cl.: H05K 1/02, H05K 3/02, H01R 24/00

(54) **VERFAHREN ZUM HF-ABSTIMMEN EINER ELEKTRISCHEN ANORDNUNG SOWIE EINE HIERZU GEEIGNETE LEITERPLATTE**
METHOD FOR HIGH-FREQUENCY TUNING AN ELECTRICAL DEVICE, AND A PRINTED CIRCUIT BOARD SUITABLE THEREFOR
PROCEDE D'ACCORDAGE HF D'UN DISPOSITIF ELECTRIQUE ET CARTE DE CIRCUITS IMPRIMES CONCUE A CET EFFET

(30) Priorität: 11.03.2003 DE 10310434
(43) Veröffentlichungstag der Anmeldung: 07.12.2005
(73) Patentinhaber: Tyco Electronics Services GmbH, 8200 Schaffhausen (CH)
(72) Erfinder: BRESCHE, Peter, 10589 Berlin (DE); HETZER, Ulrich, 15831 Mahlow (DE)
(74) Vertreter: Patentanwälte Bressel und Partner mbB
(86) Internationale Anmeldenummer: PCT/EP2004/001952
(87) Internationale Veröffentlichungsnummer: WO 2004/082343

(56) Entgegenhaltungen:
- WO-A-00/55870
- DE-A- 10 051 097
- DE-A- 19 646 774
- GB-A- 2 133 933
- US-A- 4 905 358
- US-A- 6 023 200
- US-B1- 6 333 472
- US-B1- 6 428 362

## Beschreibung

Die Erfindung betrifft ein Verfahren zum HF-Abstimmen einer elektrischen Anordnung sowie eine hierzu geeignete Leiterplatte.

Aus der EP 0 525 703 A1 ist eine Steckverbindung für Computernetze im Hausbereich bekannt, bestehend aus einem Stecker- und einem Buchsenteil, wobei eine Einrichtung zur Nebensprechkompensation in der Steckverbindung angeordnet ist, mit der die Nebensprechdämpfung zwischen der Sende- und der Empfangs-Leiterschleife erhöhbar ist. Hierzu ist eine Leiterplatine in dem Buchsenteil oder dem Steckerteil der Steckverbindung zwischen den Anschlüssen des Steckkabels und den Anschlüssen zur Verkabelung angeordnet, wobei die Leiterführungen der Sende- und Empfangs-Leiterschleifen auf der Leiterplatine räumlich weitgehend getrennt sind. Die Einrichtungen zur Nebensprechkompensation sind beispielsweise diskrete Bauteile wie Kondensatoren oder Spulen, die einstellbar sind. Nachteilig an der bekannten Steckverbindung ist, dass die diskreten Bauteile relativ teuer und groß sind.

Aus der US 6 023 200 ist weiterer HF-Steckverbinder bekannt.

Aus der DE 100 51 097 A1 ist ein elektrischer Steckverbinder bekannt, umfassend ein Steckverbindergehäuse, eine Leiterplatte mit zwei Sätzen von Kontaktelementen, wobei der erste Satz der Kontaktelemente auf der Vorderseite der Leiterplatte angeordnet ist und in eine Öffnung im Steckverbindergehäuse ragt und der zweite Satz von Kontaktelementen auf der Rückseite der Leiterplatte angeordnet ist und die Kontaktelemente des zweiten Satzes als Schneid-Klemm-Kontakte ausgebildet sind, wobei der Steckverbinder einen Kabelmanager umfasst, der eine durchgehende Öffnung aufweist und auf der Vorderseite mit Führungen für mit den Schneid-Klemm-Kontakten zu kontaktierende Adern ausgebildet ist, wobei die Führungen im Bereich der Schneid-Klemm-Kontakte mit vertieften Aufnahmen für die Schneid-Klemm-Kontakte ausgebildet und der Isabelmanager mit dem Steckverbindergehäuse verrastbar ist.

Aus der DE 196 46 774 A1 ist ein Verfahren zum Abgleich einer HF-Schaltung bekannt.

Aufgrund der zunehmenden Bandbreite bei der Datenübertragung in der Telekommunikations- und Datentechnik müssen die Adern, Kontakte und Leiterbahnen sehr definiert zueinander ausgebildet sein, um die geforderten Werte für die Nebensprechdämpfung einzuhalten. Dies bedingt äußerst geringe Toleranzen, die bei automatisierten Fertigungsprozessen nur schwer einzuhalten sind.

Der Erfindung liegt daher das technische Problem zugrunde, ein Verfahren zum Abstimmen eines HF-Steckverbinders, insbesondere einer RJ-45-Buchse, mit mindestens einer Leiterplatte, wobei die Leiterplatte Kontaktstellen für HF-Kontakte und Kontaktstellen für die Schneid-Klemm-Kontakte umfasst, wobei jeweils eine Kontaktstelle für die HF-Kontakte mit jeweils einer Kontaktstelle für die Schneid-Klemm-Kontakte verbunden ist, bereitzustellen.

Die Lösung des technischen Problems ergibt sich durch der Gegenstand mit den Merkmalen des Patentanspruches 1. Weitere vorteilhafte Ausgestaltungen der Erfindung ergeben sich aus den Unteransprüchen 2 bis 6.

Gemäß der Erfindung wird der frequenzabhängige Parameter an der unbestückten Leiterplatte bestimmt und eingestellt. Dem liegt die Erkenntnis zugrunde, dass insbesondere bei HF-Steckverbindern die Leiterplatte selbst den Großteil der HF-Toleranzen verursacht. Diese Toleranzen sind in der Regel geometrische Toleranzen der Layout-Elemente, wie beispielsweise Leiterbahnen und Toleranzen der Dielektrizitätskonstante des Materials der Leiterplatte. Die automatische Messung an einer unbestückten Leiterplatte ist erheblich einfacher als an einer bestückten bzw. sogar in einem Gehäuse verbauten Leiterplatte. Somit lässt sich die Abstimmung der Gesamtanordnung bereits frühzeitig in dem Herstellungsprozess der Leiterplatte integrieren. Die Einspeisung bzw. Messung erfolgt dabei vorzugsweise zentrisch in den Lötaugen der Kontaktstellen.

Gemäß der Erfindung wird in einem ersten Schritt nur ein Teil der abgeschätzten notwendigen Leiterbahnverkürzung vorgenommen. Anschließend wird dann der frequenzabhängige Parameter erneut gemessen. Anhand der gemessenen Änderung wird dann die restliche noch zu entfernende oder zu trennende Leiterbahnlänge bestimmt. Hierdurch werden auch die Toleranzen der Leiterbahnen bei der Abstimmung berücksichtigt. Die Leiterbahnverkürzung kann dabei auch auf mehr als zwei Schritte aufgeteilt werden.

In einer weiteren bevorzugten Ausführungsform wird beim Trennen der Leiterbahn der letzte Trennschnitt breiter als der erste Trennschnitt durchgeführt. Dieser breitere Schnitt minimiert den kapazitiven Einfluss des abgetrennten Teils der Leiterbahn.

In einer weiteren bevorzugten Ausführungsform wird als frequenzabhängiger Parameter das Nahnebensprechen bestimmt, was die Abstimmung vereinfacht, da der direkt zu optimierende Parameter bestimmt wird, so dass weitere Abschätzungen hinsichtlich des Einflusses des Parameters auf das Nahnebensprechen entfallen, was beispielsweise bei einer reinen Kapazitätsmessung der Fall wäre.

Vorzugsweise erfolgt die Trennung der Leiterbahn mittels eines Lasers, vorzugsweise mittels eines kurzwelligen Lasers mit einer Wellenlänge kleiner als 600 nm. Das Trennen der Leiterbahn mittels eines Lasers ist äußerst schnell und leicht automatisierbar. Prinzipiell kann die Trennung oder Entfernung der Leiterbahn auch mechanisch, beispielsweise mittels Fräsen oder elektrisch durch Wegbrennen mittels Überstromes, erfolgen.

In einer weiteren bevorzugten Ausführungsform ist dem Laser ein optisches Positionier-System zugeordnet. Hierdurch kann eine definiertere Trennung der Leiterbahnen durchgeführt werden, ohne eng benachbarte Leiterbahnen zu beschädigen bzw. die zu trennende Leiterbahn nicht vollständig zu trennen.

Beim Entfernen bzw. Trennen der Leiterbahn kann es dazu kommen, dass sich Kupferpartikel auf der Leiterplatte niederschlagen, die wiederum die Überspannungsfestigkeit reduzieren. Daher erfolgt vorzugsweise nach dem Trennen bzw. Entfernen der Leiterbahn ein Reinigungsschritt zum Entfernen der Kupferpartikel und/oder anderer Verunreinigungen.

Die Erfindung wird nachfolgend anhand eines bevorzugten Ausführungsbeispieles näher erläutert. Die Fig. zeigen:
- Fig. 1: eine Explosionsdarstellung eines Steckverbinders zur Übertragung von HF-Daten (Stand der Technik),
- Fig. 2: eine Leiterplatte zum Einsatz in einem Steckverbinder nach Fig. 1,
- Fig. 3: ein schematisches Ersatzschaltbild der Leiterplatte,
- Fig. 4: ein schematischer Frequenzgang des Nahnebensprechens und
- Fig. 5: eine Kurvenschar der Dämpfung D des Nahnebensprechens in Abhängigkeit der Länge der zu entfernenden Leiterbahn.

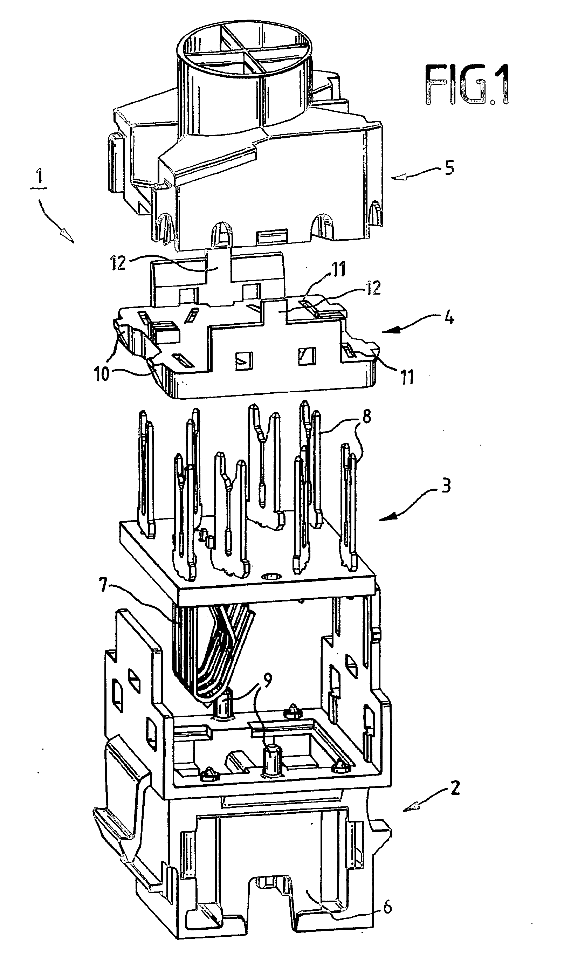

In der Fig. 1 ist ein Steckverbinder 1 in einer Explosionsdarstellung gezeigt. Der Steckverbinder 1 umfasst ein Steckverbindergehäuse 2, eine Leiterplatte 3, einen Niederhalter 4 und einen Kabelmanager 5. Das Steckverbindergehäuse 2 ist im dargestellten Beispiel als Buchsengehäuse mit verschiedenen Rast- und Einsteckmitteln ausgebildet. An den Seitenflächen ist das Steckverbindergehäuse 2 mit einem Schirmblech 6 ausgebildet. Die Leiterplatte 3 ist auf ihrer Vorderseite mit einem ersten Satz von Kontakten 7 und auf ihrer Rückseite mit einem zweiten Satz von Schneid-Klemm-Kontakten 8 bestückt. Jeweils ein Kontakt 7 des ersten Satzes ist mit einem Kontakt 8 des zweiten Satzes verbunden. Die Leiterplatte 3 wird dann in das Steckverbindergehäuse 2 eingeführt. Dabei durchdringen Zylinderstifte 9 des Steckverbindergehäuses 2 Bohrungen in der Leiterplatte 3, so dass Steckverbindergehäuse 2 und Leiterplatte 3 zueinander justiert und fixiert sind. Die als HF-Kontakte ausgebildeten Kontakte 7 des ersten Satzes ragen dann in eine von der Vorderseite des Steckverbindergehäuses zugängliche Öffnung hinein. Anschließend wird der Niederhalter 4 über die Kontakte 8 des zweiten Satzes geschoben und mit dem Steckverbindergehäuse 2 verrastet. Hierzu ist der Niederhalter 4 an der Stirnseite mit Rastnasen 10 ausgebildet und weist durchgehende Öffnungen 11 für die Schneid-Klemm-Kontakte 8 auf. Des weiteren ist der Niederhalter 4 mit zwei Rasthaken 12 ausgebildet, die zur Verrastung mit dem Kabelmanager 5 dienen.

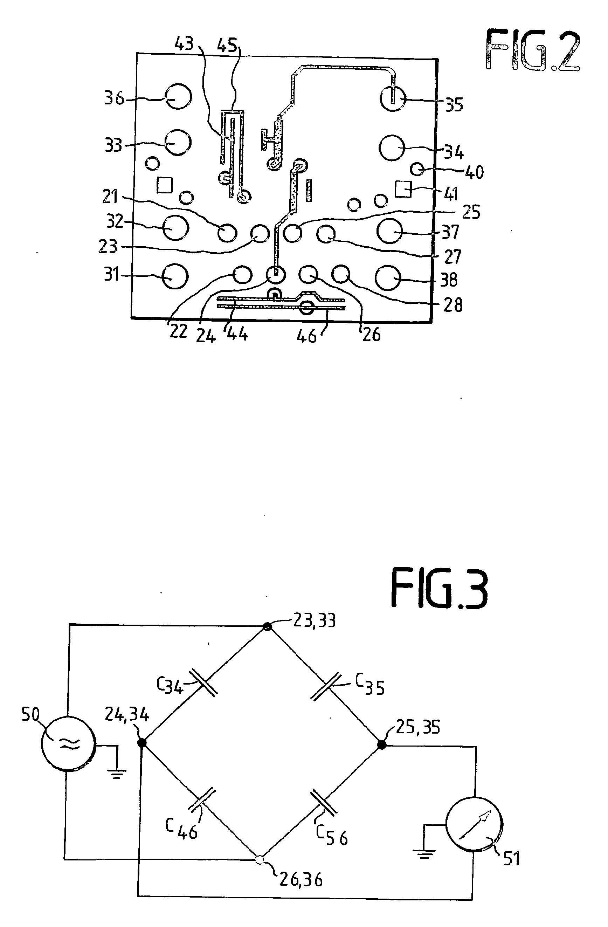

In der Fig. 2 ist die unbestückte Leiterplatte 3 dargestellt. Die Leiterplatte 3 umfasst acht Kontaktstellen 21 - 28 bzw. Kontaktlöcher für die HF-Kontakte und acht Kontaktstellen 31 - 38 für die Schneid-Klemm-Kontakte. Des weiteren umfasst die Leiterplatte 3 weitere Durchkontaktierungen 40 zur Verbindung von Leiterbahnen auf der Vorder- und Rückseite und Innenlagen der Leiterplatte, wobei die Durchkontaktierungen 40 als kleine Kreise dargestellt sind. Die Bohrungen 41 in der Leiterplatte 3 sind dabei als kleine Quadrate dargestellt. Die Leiterbahnen, die die Kontaktstellen 21 - 28 mit ihrer jeweils zugeordneten Kontaktstelle 31 - 38 verbinden, sind mit Ausnahme der zwei Teilstücke von der Kontaktstelle 24 bzw. 35 nicht dargestellt, weil diese auf der Rückseite bzw. Innenlagen der Leiterplatte angeordnet sind. Zusätzlich zu den elektrischen verbindenden Leiterbahnen zwischen zwei Kontaktstellen 21 - 28 bzw. 31 - 38 sind vier Leiterbahnen 43 - 46 angeordnet, die jeweils einseitig mit einer Kontaktstelle 23 - 26 verbunden sind. Dabei bilden die beiden Leiterbahnen 44 und 46 einen Kondensator zwischen den Kontaktstellen 24 und 26. Entsprechend bilden die beiden Leiterbahnen 43 und 45 einen Kondensator zwischen den Kontaktstellen 23 und 25. Vorzugsweise ist in einer Innenlage eine weitere Leiterbahn angeordnet, die mit der Leiterbahn 44 elektrisch verbunden ist und unter der Leiterbahn 46 liegt. Schaltungstechnisch bilden jeweils die Kontaktstellen 21, 22; 23, 26; 24, 25 und 27, 28 bzw. deren zugeordnete Kontakte ein Kontaktpaar. Dabei sind die beiden äußeren Kontaktpaare 21, 22 bzw. 27, 28 relativ unkritisch bezüglich des Nahnebensprechens. Problematisch hingegen sind die beiden innenliegenden und verschachtelten Kontaktpaare 23, 26 bzw.24, 25. Die dabei störenden Kapazitäten liegen zwischen 23 und 24 bzw. 25 und 26, da die anderen Kopplungen aufgrund der größeren Abstände vernachlässigbar sind.

In der Fig. 3 ist das sich ergebende Ersatzschaltbild inklusive schematischen Messaufbau dargestellt. Dabei stellen die Kondensatoren C₄₆ und C₃₅ im Wesentlichen die durch die Leiterbahnen 44 und 46 bzw. 43 und 45 gebildeten Kondensatoren dar, wohingegen die Kondensatoren C₃₄ bzw. C₅₆ sich durch die benachbarten Kontaktstellen 23, 33 sowie zugehöriger Leiterbahn und 24, 34 mit Leiterbahn bzw. 25, 35 mit Leiterbahn und 26, 36 mit Leiterbahn bilden. Diese Brückenschaltung gilt es nun abzugleichen, um das Nahnebensprechen unter die geforderten Werte zu drücken. Vor dem Abgleichen wird zunächst die Unsymmetrie bestimmt, in dem als frequenzabhängiger Parameter das Nahnebensprechen eines Kontaktpaares bestimmt wird. Im vorliegenden Fall wird das Übersprechen des Kontaktpaares 23, 33 und 26, 36 auf das Kontaktpaar 24, 34; 25, 35 bestimmt. Da die Messung vorzugsweise an der unbestückten Leiterplatte 3 erfolgt, werden die Kontaktstellen 33 - 36 impedanzgerecht abgeschlossen. Mittels eines Networkanalysers, der in Fig. 3 durch den Frequenzgenerator 50 und die Messeinrichtung 51 symbolisiert ist, wird dann das Nahnebensprechen an den Kontaktstellen 25, 24 gemessen, wenn HF-Signale in die Kontaktstellen 23, 26 eingekoppelt werden. Das Einspeisen bzw. Messen der HF-Signale erfolgt dabei vorzugsweise mittels einer zentrischen Kontaktierung in den Lötaugen der Kontaktstellen 23 - 26.

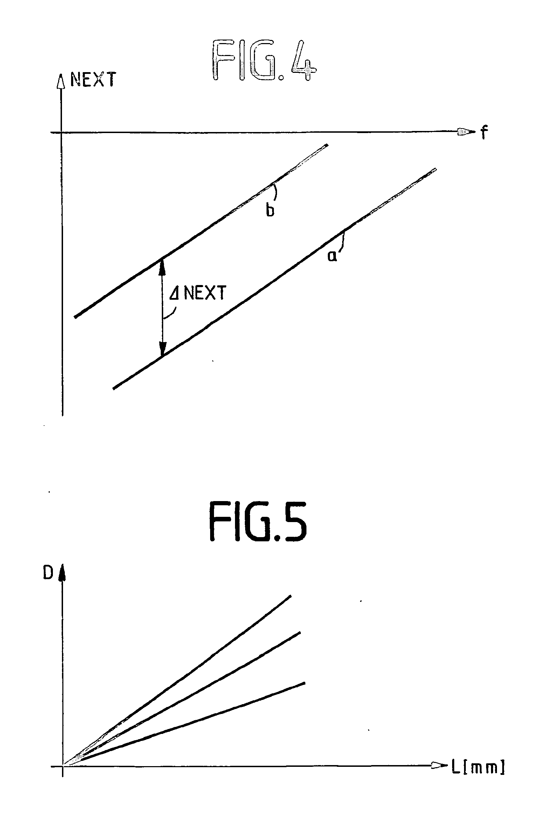

In der Fig. 4 ist schematisch der Frequenzgang des Nahnebensprechens NEXT dargestellt, wobei der Verlauf a ein Soll-Nahnebensprechen und der Verlauf b das gemessene Ist-Nahnebensprechen einer vermessenen Leiterplatte darstellt. Das Soll-Nahnebensprechen wird beispielsweise mittels eines Golden-Device bestimmt. Dabei ist das gemessene Nahnebensprechen um den Betrag □ NEXT zu groß, so dass dieser durch Kürzung der Leiterbahnen und somit Verringerung der Kapazität kompensiert werden muss. Das Maß, wie viele mm Leiterbahn welcher Kapazität entsprechen und somit der Nahnebensprech-Dämpfung D, ist abhängig von den Toleranzen der Leiterplatte, wie beispielsweise Dielektrizitäts-Konstante oder Abstand der Leiterbahnen. Daher existiert nicht eine einzige Gerade, sondern eine ganze Kurvenschar, was schematisch in Fig. 5 dargestellt ist. Da die Toleranzen unbekannt sind, muss ggf. zunächst bestimmt werden, welche Kurve auf die abzustimmende Leiterplatte zutrifft. Hierzu wird zunächst ein Stück Leiterbahn entfernt bzw. durchtrennt und erneut gemessen. Aufgrund der festgestellten Zunahme an Dämpfung D kann dann die zugehörige Kurve bestimmt werden. Ist hingegen die gewünschte Dämpfung größer als mit der steilsten Kurve erreichbar ist, kann ohne Zwischenschritt die gesamte Leiterbahn entfernt bzw. durchtrennt werden. Anschließend wird das Verfahren am anderen Kondensator wiederholt.

Das Durchtrennen der Leiterbahn erfolgt vorzugsweise mittels eines kurzwelligen Lasers, dessen Leistung und Fokussierung auf die zu trennende Kupfer-Leiterbahn derart abgestimmt ist, dass vorwiegend nur diese abgetragen wird. Der Vorteil eines Lasers ist dessen hohe Geschwindigkeit bei hoher Reproduzierbarkeit, so dass der Abstimmungsvorgang sich gut automatisieren lässt.

### Bezugszeichenliste

1) Steckverbinder
2) Steckverbindergehäuse
3) Leiterplatte
4) Niederhalter
5) Kabelmanager
6) Schirmblech
7) Kontakte
8) Kontakte
9) Zylinderstifte
10) Rastnasen
11) Öffnungen
12) Rasthaken
21) Kontaktstellen (für HF-Kontakte)
22) Kontaktstellen (für HF-Kontakte)
23) Kontaktstellen (für HF-Kontakte)
24) Kontaktstellen (für HF-Kontakte)
25) Kontaktstellen (für HF-Kontakte)
26) Kontaktstellen (für HF-Kontakte)
27) Kontaktstellen (für HF-Kontakte)
28) Kontaktstellen (für HF-Kontakte)
31) Kontaktstelle (für Schneid-Klemm-Kontakt)
32) Kontaktstelle (für Schneid-Klemm-Kontakt)
33) Kontaktstelle (für Schneid-Klemm-Kontakt)
34) Kontaktstelle (für Schneid-Klemm-Kontakt)
35) Kontaktstelle (für Schneid-Klemm-Kontakt)
36) Kontaktstelle (für Schneid-Klemm-Kontakt)
37) Kontaktstelle (für Schneid-Klemm-Kontakt)
38) Kontaktstelle (für Schneid-Klemm-Kontakt)
40) Durchkontaktierung
41) Bohrung
43) Leiterbahn
44) Leiterbahn
45) Leiterbahn
46) Leiterbahn
50) Frequenzgenerator
51) Messeinrichtung

## Patentansprüche

1. Verfahren zum HF-Abstimmen eines HF-Steckverbinders (1), umfassend eine Leiterplatte (3), wobei die Leiterplatte Kontaktstellen (21-28) für HF-Kontakte und Kontaktstellen (31-38) für Schneid-Klemm-Kontakte umfasst, wobei jeweils eine Kontaktstelle (21-28) für die HF-Kontakte mit jeweils einer Kontaktstelle (31-38) für die Schneid-Klemm-Kontakte verbunden ist, wobei zwischen den HF-Kontakten kapazitive Kopplungen auftreten, die ein Nahnebensprechen (NEXT) verursachen, wobei mindestens eine nur einseitig mit einer Kontaktstelle (26) eines elektrischen Kontaktes verbundene erste Leiterbahn (46) auf der Leiterplatte (3) angeordnet ist, die mit mindestens einer zweiten auf und/oder in der Leiterplatte (3) angeordnete Leiterbahn (44) einen Kondensator (C₄₆) bildet,
**dadurch gekennzeichnet, dass**
mindestens ein frequenzabhängiger Parameter der Anordnung gemessen wird, der frequenzabhängige Parameter mit einem SollParameter verglichen wird und in Abhängigkeit von der Abweichung die einseitig kontaktierte Leiterbahn (46) teilweise entfernt oder durchtrennt wird, wobei als frequenzabhängiger Parameter ein Nahnebensprechen (NEXT) bestimmt wird, wobei in einem ersten Schritt nur ein Teil der abgeschätzten notwendigen Leiterbahnverkürzung (L) vorgenommen wird, das Nahnebensprechen (NEXT) erneut gemessen wird und dann die restliche noch zu entfernende oder zu trennende Leiterbahnlänge bestimmt wird und diese in einem zweiten Schritt entfernt oder durchgetrennt wird.

2. Verfahren nach Anspruch 1, **dadurch gekennzeichnet, dass** mindestens zwei abstimmbare Kondensatoren (C₄₆, C₃₅) auf der Leiterplatte (3) angeordnet werden, wobei das Verfahren für beide Kondensatoren (C₄₆, C₃₅) ausgeführt wird.

3. Verfahren nach einem der vorangegangenen Ansprüche, **dadurch gekennzeichnet, dass** der frequenzabhängige Parameter an der unbestückten Leiterplatte (3) bestimmt wird.

4. Verfahren nach einem der vorangegangenen Ansprüche, **dadurch gekennzeichnet, dass** die Trennung der Leiterbahn (46, 45) im zweiten Schritt breiter als im ersten Schritt durchgeführt wird.

5. Verfahren nach einem der vorangegangenen Ansprüche, **dadurch gekennzeichnet, dass** die Trennung der Leiterbahn (46, 45) mittels eines Lasers erfolgt.

6. Verfahren nach einem der vorangegangenen Ansprüche, **dadurch gekennzeichnet, dass** die Steuerung des Lasers durch ein optisches System unterstützt wird.

## Claims

1. Method for high-frequency tuning a high-frequency plug-in connector (1) comprising a printed circuit board (3), wherein the printed circuit board comprises contact points (21-28) for high-frequency contacts and contact points (31-38) for insulation piercing contacts, wherein in each case one contact point (21-28) for the high-frequency contacts is connected to, in each case, one contact point (31-38) for the insulation piercing contacts, wherein capacitive couplings which bring about near-end crosstalk (NEXT) occur between the high-frequency contacts, wherein at least one first conductor track (46) which is connected only on one side to a contact point (26) of an electrical contact is arranged on the printed circuit board (3) and forms a capacitor (C₄₆) with at least one second conductor track (44) which is arranged on and/or in the printed circuit board (3),
**characterized in that**
at least one frequency-dependent parameter of the arrangement is measured, the frequency-dependent parameter is compared with a setpoint parameter, and the conductor track (46) with which contact is made on one side is partially removed or cut as a function of the difference, wherein near-end crosstalk (NEXT) is determined as frequency-dependent parameter, wherein in a first step only a portion of the estimated necessary shortening (L) of the conductor track is performed, the near-end crosstalk (NEXT) is measured again, and the remaining conductor track length which is still to be removed or cut is determined and is removed or cut in a second step.

2. Method according to Claim 1, **characterized in that** at least two tunable capacitors (C₄₆, C₃₅) are arranged on the printed circuit board (3), wherein the method is carried out for both capacitors (C₄₆, C₃₅).

3. Method according to one of the preceding claims, **characterized in that** the frequency-dependent parameter is determined on the unpopulated printed circuit board (3).

4. Method according to one of the preceding claims, **characterized in that** the cutting of the conductor track (46, 45) is wider in the second step than in the first step.

5. Method according to one of the preceding claims, **characterized in that** the cutting of the conductor track (46, 45) is carried out by means of a laser.

6. Method according to one of the preceding claims, **characterized in that** the control of the laser is supported by means of an optical system.

## Revendications

1. Procédé d'accordage HF d'un connecteur enfichable HF (1), comprenant une carte à circuits imprimés (3), la carte à circuits imprimés comprenant des plages de contacts (21-28) pour des contacts HF et des plages de contact (31-38) pour des contacts autodénudants, une plage de contact (21-28) pour les contacts HF étant à chaque fois connectée à une plage de contact (31-38) respective pour les contact autodénudants, des accouplements capacitifs se produisant entre les contacts HF, lesquels provoquent une paradiaphonie (NEXT), au moins une première piste conductrice (46) connectée seulement d'un côté à une plage de contact (26) d'un contact électrique étant disposée sur la carte à circuits imprimés (3), laquelle forme un condensateur (C₄₆) avec au moins une deuxième piste conductrice (44) disposée sur et/ou dans la carte à circuits imprimés (3),
**caractérisé en ce que**
l'on mesure au moins un paramètre de l'agencement, dépendant de la fréquence, le paramètre dépendant de la fréquence est comparé avec un paramètre de consigne et, en fonction de l'écart, la piste conductrice (46) mise en contact d'un côté est au moins partiellement enlevée ou séparée, une paradiaphonie (NEXT) étant déterminée en tant que paramètre dépendant de la fréquence, seulement une partie du raccourcissement nécessaire évalué de la piste conductrice (L) étant effectuée dans une première étape, la paradiaphonie (NEXT) étant mesurée à nouveau puis la longueur de piste conductrice restante devant encore être enlevée ou séparée étant déterminée et celle-ci étant enlevée ou séparée dans une deuxième étape.

2. Procédé selon la revendication 1, **caractérisé en ce qu'**au moins deux condensateurs réglables (C₄₆, C₃₅) sont disposés sur la carte à circuits imprimés (3), le procédé étant mis en oeuvre pour les deux condensateurs réglables (C₄₆, C₃₅).

3. Procédé selon l'une quelconque des revendications précédentes, **caractérisé en ce que** le paramètre dépendant de la fréquence est adapté à la carte à circuits imprimés (3) non équipée.

4. Procédé selon l'une quelconque des revendications précédentes, **caractérisé en ce que** la séparation de la piste conductrice (46, 45) dans la deuxième étape est plus importante que dans la première étape.

5. Procédé selon l'une quelconque des revendications précédentes, **caractérisé en ce que** la séparation de la piste conductrice (46, 45) s'effectue au moyen d'un laser.

6. Procédé selon l'une quelconque des revendications précédentes, **caractérisé en ce que** la commande du laser est assistée par un système optique.
